# EUROPEAN PATENT APPLICATION

(11) **EP 3 293 639 A1**
(43) Date of publication of application: **14.03.2018**
(21) Application number: 16187643.8
(22) Date of filing: 07.09.2016
(51) Int. Cl.: G06F 15/78, G06F 17/50

(54) **RECONFIGURABLE DIGITAL SIGNAL PROCESSING DEVICE**

(71) Applicant: LYNX Technik AG, 64331 Weiterstadt (DE)
(72) Inventor: Urvoy, Carol, 64289 Darmstadt (DE); Dose, Frances, 64295 Darmstadt (DE); Russell, Steve, Santa Clarita, CA 91321 (US)
(74) Representative: Weilnau, Carsten

(57) **Abstract**

In one aspect the invention relates to a digital signal processing device (16) for processing of digital audio signals, image signals or video signals, the processing device comprising:
- a field programmable gate array FPGA (20) configurable in accordance to various user-definable constellations (81, 82, 83),
- at least one of a signal input (11, 13) and a signal output (12, 14) connected to the FPGA (20),
- a storage (60),
- at least one interface (40, 50), and
- a central processing unit CPU (30) connected to the FPGA (20), connected to the storage (60) and connected to the at least one interface (40, 50),
- wherein the storage (60) comprises a primary constellation storage space (61) configured to store an active constellation (81') of the FPGA (20) and wherein the storage (60) comprises at least one secondary constellation storage space (63) configured to store at least one or several inactive constellations (82, 83) of the FPGA (20).

## Description

### Field of the invention

The present invention relates to the field of digital signal processing and in particular to the field of digital signal processing of digital audio signals, digital image signals or digital video signals. In another aspect the invention relates to a configurator connectable to the digital signal processing device and to a computer program stored in such a configurator and/or stored in a digital signal processing device.

### Background

Hardware for video-, image- and/or audio-signal processing has traditionally been rigid and inflexible in its functionality. A single hardware device performs the tasks it was programmed to perform when it was manufactured and cannot be modified at a later date. Document DE 102 25 227 A1 for instance relates to digital video image generation with the capability to produce still images. In this document various hardware implementations for a video-/still-image generation system are discussed. It may be based on a discrete logic circuit, an application-specific integrated circuit, a programmable gate array or a field programmable gate array.

It is therefore an object of the present invention to provide an improved digital signal processing device, a configurator connectable to such a digital signal processing device and to provide a computer program for such a configurator and/or for such a digital signal processing device that allows and enables universal and versatile reconfiguration of the digital signal processing device. Reconfiguration of the digital signal processing device should be reliable, fast and intuitive for the end user. There should be provided a rather intuitive look and feel for the end user on how to reconfigure the digital signal processing device. Moreover, the digital signal processing device should be also reconfigurable in a standalone configuration, i.e. when disconnected from a configurator. It is a general aim to provide hardware components that are universally configurable for totally different purposes for the processing of digital audio signals, digital image signals or digital video signals.

### Summary of the invention

In one aspect a digital signal processing device for processing of digital audio signals, digital image signals or digital video signals is provided. The processing device comprises a field programmable gate array (FPGA) configurable in accordance to various user-definable constellations. The processing device further comprises at least one of a signal input and a signal output connected to the FPGA. The processing device further comprises a storage and at least one interface as well as a central processing unit (CPU). The central processing unit is connected to the FPGA, to the storage and to the at least one interface. The storage comprises a primary constellation storage space that is configured to store an active constellation of the FPGA. The storage further comprises at least one secondary constellation storage space that is configured to store at least one or several inactive constellations of the FPGA.

By providing a storage configured to store at least two different constellations deployable on the FPGA the digital signal processing device can be provided with at least two different constellations according to which the FPGA could be deployed or reconfigured on-demand. The inactive constellation and the active constellation may be swapped, e.g. by storing the inactive constellation in the primary constellation storage space. Then, the central processing unit may automatically conduct or trigger a reprogramming of the FPGA in accordance to the active constellation now stored in the primary constellation storage space. As a consequence, the FPGA will be reconfigured and will provide a totally different signal processing functionality. By providing the storage with primary and secondary constellation storage spaces at least two different constellations of the FPGA can be stored directly in the digital signal processing device. On demand of a user and optionally triggered by the CPU the FPGA and hence the entire digital signal processing device are reconfigurable without the necessity to communicate with any auxiliary or external electronic device configured to conduct a reconfiguration of the FPGA, such as to conduct a firmware installation of the digital signal processing device.

Typically, the digital signal processing device comprises both, a signal input and a signal output. Both, the signal input as well as the signal output are connected to the FPGA. The signal input and the signal output are connected via the FPGA and via a signal path defined by the active constellation of the FPGA. However, there are configurations of the digital signal processing device conceivable, wherein there will be used only one of a signal input and a signal output. If the digital signal processing device is for instance configured as a test generator for video processing it may comprise only a single signal output. It may then be void of a signal input. If the digital signal processing device should be configured as a video signal analyzer it may comprise only a single signal input. It may then be void of a signal output.

The central processing unit is particularly configured to reconfigure the FPGA. The CPU may further assist the FPGA during runtime and for performing digital signal processing. The constellation stored in the primary or secondary constellation storage space is typically provided in form of a hardware description language and/or in form of an XML file. It may be generally sufficient when the storage is exclusively equipped with primary and secondary constellation storage spaces. A binary file, i.e. bitfile, that will be finally used to configure or to reconfigure the FPGA may be provided by the CPU on demand on the basis of the active constellation.

According to another embodiment the storage also comprises a primary bitfile storage space that is configured to store an active bitfile of the FPGA currently deployed on the FPGA. The active bitfile corresponds to the active constellation stored in the primary constellation storage space. By providing a primary bitfile storage space the binary files, i.e. the bitfiles, to configure or to reconfigure the FPGA can be locally stored in the digital signal processing device. This facilitates configuration and reconfiguration of the FPGA.

Furthermore and according to another embodiment the storage also comprises a secondary bitfile storage space configured to store at least one or several inactive bitfiles each of which being deployable on or in the FPGA.

With a secondary bitfile storage space also inactive bitfiles can be readily stored in the storage. For a configuration or reconfiguration of the FPGA it may be sufficient to replace the active bitfile by an inactive bitfile. Hence, an inactive bitfile previously stored in the secondary bitfile storage space might be shifted towards the primary bitfile storage space, thereby removing or replacing the previously active bitfile. Once the content of the primary bitfile storage space has changed the CPU automatically starts to configure or to reconfigure the FPGA in accordance to the active bitfile currently stored in the primary bitfile storage space.

By providing the possibility to store one or several inactive bitfiles in the secondary bitfile storage space of the storage the digital signal processing device may be quickly and easily switched between different configurations even without the necessity to connect to a separate or external configurator, such as a personal computer, a tablet computer or the like.

In another embodiment the constellations stored in the primary and/or secondary constellation storage space are each descriptive of a signal path inside the FPGA and optionally descriptive of at least one signal processing function on the signal path.

The constellations, the hardware description language and/or the XML file used to describe the constellation and the overall functionality of the digital signal processing provided by the FPGA define at least a signal path, typically connecting the at least one signal input with the at least one signal output of the FPGA. Along the signal path there are typically provided various nodes or notches acting as place holders for signal processing functions that may be positioned at predefined sections of a signal path. A constellation may comprise several signal paths.

The constellation may comprise two or more signal inputs as well as two or more signal outputs. Moreover, signal paths may merge in the FPGA so that a constellation may comprise two or more signal inputs but a reduced number of signal outputs. Concurrently it is also conceivable, that a signal path branches off into two or more additional signal paths. Hence, a constellation may comprise one or more signal inputs and a larger number of signal outputs. There may be provided basic constellations that are void of signal processing functions. Such basic constellations consist of at least one signal path having at least one or several nodes or notches acting as place holders for one or several signal processing functions. Such basic constellations represent the general signal flow architecture of the FPGA. At the nodes or notches of the signal path of a basic constellation various signal processing functions may be positioned in accordance to a user-given definition or in accordance with user preferences.

A constellation comprising a signal path and comprising at least one signal processing function positioned on the signal path may be simply denoted as a constellation or configured constellation. Configured constellations and/or base constellations describing a digital signal processing device that is generally implementable or deployable in the FPGA are usually stored in the primary constellation storage space. They may be also stored or additionally stored in the secondary constellation storage space.

By providing constellations with a signal path and optionally with at least one signal processing function a large variety of differently configured FPGAs and differently configured digital signal processing devices can be provided, simply by reconfiguring the FPGA. Cost expenditure for end consumers for acquisition of hardware can be remarkably reduced. One and the same hardware piece, i.e. one and the same digital signal processing device, may be purchased multiple times. Each one of the digital signal processing devices may be configured in accordance to user-specific demands. One or more digital signal processing devices may be further connected with each other so that a digital signal processing system may be set up consisting of numerous digital signal processing devices each of which having the same hardware but each of which being configured and deployed differently in order to provide user-specific individual digital signal processing functions.

In another embodiment the CPU is configured to provide a bitfile on the basis of a constellation and to store the provided bitfile as an active bitfile in the primary bitfile storage space. Alternatively or additionally the CPU is configured to load or to select the bitfile on the basis of a constellation and to store the loaded or selected bitfile as a passive bitfile in the secondary bitfile storage space. Storing the bitfile as an active bitfile in the primary bitfile storage space may directly trigger a respective configuration or reconfiguration of the FPGA. Storing of the bitfile as a passive bitfile in the secondary bitfile storage space has no influence on the operation of the FPGA and on the operation of the digital signal processing device. Hence, a CPU may provide or load a new bitfile even during runtime of a digital signal processing device and may store the passive bitfile in the secondary bitfile storage space. Then and at any later time the passive bitfile stored in the secondary bitfile storage space may swap role or may swap position with the active bitfile in the primary bitfile storage space. Hence, the FPGA may be reconfigured in accordance to the binary instructions of the passive bitfile, that became the active bitfile in the primary bitfile storage space.

According to a further embodiment for providing a bitfile on the basis of a constellation, the CPU is configured to load at least one or several default bitfiles from the secondary bitfile storage space. Each one of the default bitfiles is configured to deploy a signal processing function of the constellation on the FPGA. In other words, each one of the default bitfiles may provide a specific signal processing function when deployed on the FPGA. Assuming a constellation with a given signal path and with a first, a second and a third processing function that may distinguish from each other a respective bitfile may be provided by loading a respective first, second and third bitfile, each of which corresponding to the first, the second and the third processing function, respectively. Computational efforts for providing a bitfile from a constellation may be reduced in this way. A configuration or reconfiguration of the FPGA may be accelerated in this way.

Loading of a bitfile and deploying the loaded bitfile in the primary bitfile storage space may enable a partial reboot of the FPGA. Here, only one or more bitfiles actually loaded from the secondary bitfile storage space will be used to reconfigure the FPGA and the respective signal processing. For this only a portion of the FPGA may be subject to a reboot or may be subject to a reconfiguration whereas other portions of the FPGA remain substantially unaffected by such a partial reboot. A downtime of the FPGA during reconfiguration can be reduced in this way. Computational efforts and time required for a reconfiguration of the FPGA can be kept on a rather low level.

In another embodiment for providing a bitfile on the basis of a constellation the CPU is configured:
- to select at least two default bitfiles, to group together or to cluster the at least two default bitfiles and to form a bitfile group from the at least two selected bitfile, wherein each one of the default bitfiles is configured to deploy a signal processing function of the constellation on the FPGA. The CPU is further configured to:
- set up and to apply an application mask to the bitfile or to the bitfile group, wherein the application mask is indicative of active and inactive signal processing functions as defined in the bitfile or by the default bitfiles of the bitfile group. The application mask is hence indicative of active and inactive processing functions executable by a bitfile or deployed in a bitfile. The CPU is further configured to store the bitfile or bitfile group together with the application mask.

In other words a bitfile may comprise a group or a combination of at least two bitfiles and may hence represent at least two signal processing functions. In such a bitfile the at least two signal processing functions may be defined in a certain constellation. Hence, a first default bitfile may provide a first signal processing function and a second default bitfile may provide a second signal processing function. In the bitfile, the first default bitfile representing or corresponding to the first signal processing function may be connected in a data communicating way to the second default bitfile representing or corresponding to the second signal processing function. Hence, the bitfile containing the first and the second default bitfile and hence containing the first and the second signal processing functions may correspond to a constellation. By grouping or by clustering together at least two or even more default bitfiles or signal processing functions, the total number of bitfiles can be reduced.

In this way, a required storage space in the storage of the digital signal processing device can be reduced accordingly. Additionally, making use of a bitfile group and designing or pre-configuring a bitfile corresponding to or representing a group of signal processing functions and selectively deactivating the processing functions with the help of the application mask is of advantage to accelerate and to improve loading of a bitfiles as defined by a user-specific constellation.

With another embodiment of the digital signal processing device the application mask together with the bitfile group is controllable via a software command for selective activation or deactivation of signal processing functions when the respective bitfile and hence the respective application mask is deployed in the FPGA. The application mask therefore enables a selective activation or deactivation of signal processing functions actually deployed in or on the FPGA. In this way, the activation mask provides a kind of at least one or several software actuatable switches, by way of which selected processing functions can be activated or deactivated during runtime of the FPGA. This allows for a configuration or reconfiguration of the FPGA and hence of the entire digital signal processing device during runtime. A reconfiguration time necessary for reconfiguring the FPGA or for reconfiguring the digital signal processing device can be further minimized in this way.

It is even conceivable to group a large number of generally available default bitfiles and hence to group corresponding signal processing functions in a bitfile and to enable selective activation and deactivation of signal processing functions during runtime of the FPGA by means of an application mask as described above. In this way, required storage space for bitfiles can be further reduced.

According to another embodiment the CPU is configured to monitor the primary constellation storage space. Hence, the CPU is permanently monitoring any modifications or alternations of the primary constellation storage space. In other words, the CPU is configured to detect storing of an inactive constellation as a new active constellation in the primary constellation storage space. By way of such a monitoring providing and/or loading of a new active bitfile as well as reconfiguring of the FPGA by means of the active bitfile can be triggered. The CPU is hence configured to provide an active bitfile on the basis of an active constellation and to store the active bitfile in the primary bitfile storage space when a new constellation is stored as an active constellation in the primary constellation storage space. A new constellation may be provided by a configurator via the at least one interface. Alternatively, a new constellation may coincide with an inactive constellation stored in the secondary constellation storage space.

Furthermore, the CPU is configured to deploy the active bitfile on the FPGA when the active bitfile is stored in the primary bitfile storage space. Typically and for reconfiguring of the FPGA in a first step a new constellation is stored as an active constellation in the primary constellation storage space. The storage of the new constellation is monitored by the CPU. In response to the storage of the new constellation in the primary constellation storage space the CPU is triggered to provide or to load a new active bitfile on the basis of the new active constellation in the primary constellation storage space. Once a new active bitfile has been loaded by the CPU the CPU triggers and initiates a reconfiguration of the FPGA on the basis of the active bitfile. In this way a rather automated reprogramming or reconfiguring of the FPGA is provided.

According to a further embodiment the CPU is configured to load an inactive constellation from the secondary constellation storage space and to store the loaded inactive constellation as an active constellation in the primary constellation storage space. In this embodiment a previously generated inactive constellation is transferred into an active constellation simply by storing the constellation in the primary constellation storage space. Since the primary constellation storage space is permanently monitored by the CPU storage of the new constellation in the primary constellation storage space triggers providing, e.g. loading of a new active bitfile as well as a reconfiguration of the FPGA on the basis of the new active bitfile.

In another embodiment the CPU is configured to load an inactive bitfile from the secondary bitfile storage space. The CPU is then further configured to store the loaded inactive bitfile as an active bitfile in the primary bitfile storage space. Here, the CPU is capable to reconfigure the FPGA directly from the secondary bitfile storage space. For this, loading of a new constellation into the primary constellation storage space is not required.

Rather, a previously provided or previously generated bitfile stored as an inactive bitfile in the secondary bitfile storage space can be used as a new active bitfile. Then, a rather direct reconfiguration of the FPGA may take place. Directly loading a new active bitfile from the secondary bitfile storage space saves computational power and energy. Here, it is not required that the CPU actually generates, provides or compiles a new active bitfile from an active constellation. Loading of an inactive bitfile into the primary bitfile storage space may be conducted during runtime and with rather low demands for computational power.

According to another embodiment for replacement of an active bitfile currently deployed in the FPGA by a new bitfile the CPU is configured to determine a delta bitfile. The delta bitfile represents a difference between the active bitfile and the new bitfile that should become the new active bitfile. Here, the CPU is configured to modify and/or to reconfigure the currently deployed active bitfile by the delta bitfile. In other words, the CPU is configured to compare the active bitfile currently deployed with the new bitfile to be deployed. If there are only minor modifications between the bitfile currently deployed and the bitfile to be deployed, there is no general necessity to set up and to load the entire new bitfile into the FPGA. Rather, only those portions of the currently deployed active bitfile that deviate from the new bitfile have to be replaced by corresponding portions or sections of the new bitfile.

In other words, the CPU is configured to divide the active bitfile into a series of bitfile components and to selectively replace only those bitfile components that need replacement in order to transfer a currently deployed active bitfile into a new bitfile to be deployed. The delta bitfile generated, derived or identified by the CPU is representative about those components or portions of the currently deployed and active bitfiles that need replacement. In this way, loading and deploying of a new active bitfile into the FPGA can be accelerated and enhanced. This enables and improves the performance of the digital signal processing device in terms of reconfiguration efficiency. It may further provide or support reconfiguration of the digital signal processing device during runtime.

According to another embodiment the at least one interface is one of a front panel user interface and a data transmission interface. The front panel user interface enables selection of one of the constellations stored in the secondary constellation storage space and enables reconfiguration of the FPGA on the basis of the selected constellation. Additionally or alternatively the front panel user interface may also enable selection of one of the inactive bitfiles stored in the secondary bitfile storage space, to store the selected bitfile in the primary bitfile storage space and to enable or to trigger reconfiguration of the FPGA on the basis of the selected bitfile.

The data transmission interface is configured to provide data transmission between the CPU and an external configurator to enable configuration and/or reconfiguration of constellations that are typically to be stored in the primary constellation storage space as active constellation or in the secondary constellation storage space as inactive constellation. The data transmission interface may be configured as a wired interface or as a wireless interface. It may comprise an ethernet connector or comparable data transmission connectors. The front panel user interface may comprise a display and at least one of a selector or button in order to provide selection and activation of one of a plurality of constellations provided in the storage of the digital signal processing device.

The digital signal processing device may be configured in numerous arbitrary ways. It may emulate or may provide digital signal processing functions, in particular for digital audio signal processing, digital image signal processing and/or digital video signal processing. Signal processing functions may comprise functions such as: frame synchronizing, scaling, video adjustment, timer functions, mixer functions, upscaling/downscaling functions, converter functions just to mention a few.

According to another aspect the present invention also relates to a digital signal processing system for processing of digital audio signals, digital image signals or digital video signals. The digital signal processing system may comprise at least one, two or even more of the above mentioned digital signal processing devices. Here, a signal output of an FPGA of a first digital signal processing device may be connected to a signal input of an FPGA of a second digital signal processing device. In this way, the hardware of a multiplicity of digital signal processing devices, typically, the FPGAs of numerous digital signal processing devices may be connected in a data transmitting way in order to deploy a constellation that requires hardware performance exceeding the hardware performance of a single FPGA. In addition, available hardware of numerous digital signal processing devices may be used to realize various constellations concurrently, wherein the versatile and universal reconfigurability of the FPGAs of the digital signal processing devices enables an optimized use of the available hardware.

According to another aspect the invention relates to a configurator connectable to the digital signal processing device as described above. The configurator comprises a graphical user interface. The configurator is further configured to visualize, to define and to modify user-definable constellations of the digital signal processing device. The configurator is further configured to transfer constellations, e.g. previously defined or developed by a user, to the digital signal processing device and to store the constellations in the storage of the digital signal processing device. The configurator may comprise an interface connectable to the data transmission interface of the digital signal processing device.

The configurator may be also capable to access the storage of the digital signal processing device and to selectively store a constellation as an active constellation in the primary constellation storage space or to store a configured and user-defined constellation as an inactive constellation in the secondary constellation storage space. The configurator may comprise a personal computer or a tablet computer equipped with a respective software or computer program to enable configuration of user-definable constellations of the digital signal processing device. The graphical user interface and the software running on the configurator provide a rather intuitive look and feel. The graphical user interface and the configurator together with the computer program stored in and running on the configurator are configured to provide a visual representation of the various signal processing functions and the signal paths of the digital signal processing device when deployed in the FPGA.

According to another embodiment the configurator is not only connectable to at least one of the above mentioned digital signal processing devices, it is connectable to at least two or even more digital signal processing devices concurrently. The configurator may be connected to several digital signal processing devices via a network. In this way, a kind of a cluster of a multitude of digital signal processing devices can be connected to the configurator. The configurator is further enabled to modify or to create at least one or several constellations that are to be deployed on at least one or more FPGA and hence on at least one or more digital signal processing devices.

In this way, the configurator is able to create, to modify and/or to transfer parts of constellations to selected processing devices so that a constellation is divided among various interconnected digital signal processing devices that are all controlled by one configurator. In this way even constellations exceeding the hardware capabilities of a single digital signal processing device can be installed and deployed by connecting and by selectively configuring digital signal processing devices. Here, each digital signal processing device may provide a sub-constellation or may contribute to part of a constellation so that the combination and data transmitting connection of several digital signal processing devices provides a desired constellation.

In a further aspect the invention relates to a digital signal processing system comprising at least one or more digital signal processing devices as described above and further comprising at least one configurator for configuring the at least one or more digital signal processing devices.

In another aspect the invention also relates to a computer program stored in a configurator as described above. The computer program comprises executable instructions to visualize a signal path inside an FPGA of a digital signal processing device as described above. The executable instructions are further configured to visualize the signal path on the graphical user interface of the configurator. The computer program further comprises executable instructions to select at least one constellation of several constellations and to transmit the selected constellation as an active constellation or as an inactive constellation to the digital signal processing device. By means of the computer program stored in the configurator a versatile and universal tool is provided to configure and to modify constellations of the FPGA and hence to configure or to reconfigure the digital signal processing device in its entirety.

In a further embodiment the computer program also comprises executable instructions not only to select at least one constellation of available constellations or among a plurality of predefined constellations but the executable instructions are further configured to modify existing constellations and/or to create new constellations. Modification of constellations may include replacing existing signal processing functions from nodes or notches of a signal path of a constellation. Modification of a constellation may further include modifying of a signal path. Modified or created constellations may not only be transmitted to the digital signal processing device but may also be stored locally in the configurator. Then, at any later time and without the necessity of a data connection to the digital signal processing device a further configuration or reconfiguration of a previously stored constellation can be conducted.

In another aspect the invention also relates to a computer program stored in the digital signal processing device. The respective computer program comprises executable instructions to provide a bitfile on the basis of a constellation and to store the provided bitfile as an active bitfile in the primary bitfile storage space or to store the provided bitfile as a passive bitfile in the secondary bitfile storage space.

In one embodiment the computer program is configured to provide a bitfile on the basis of a constellation, wherein the computer program comprises executable instructions:
- to select at least two default bitfiles, to group together the at least two default bitfiles and to form a bitfile group, wherein each one of the default bitfiles is configured to deploy a signal processing function of the constellation on the FPGA,
- to set up and to apply an application mask to the bitfile group, wherein the application mask is indicative of active and inactive signal processing functions, and
- to store the bitfile group together with the application mask.

In another embodiment the computer program is configured to control or to modify the application mask for selective activation or deactivation of signal processing functions during runtime of the FPGA. In this way the FPGA and the digital signal processing device can be reconfigured during runtime.

In one embodiment the computer program comprises executable instructions to:
- to monitor the primary constellation storage space,
- to provide an active bitfile on the basis of an active constellation and to store the active bitfile in the primary bitfile storage space when a new constellation is stored as an active constellation in the primary constellation storage space, and
- to deploy the active bitfile on the FPGA when the active bitfile is stored in the primary bitfile storage space.

In particular, all features, benefits and effects described in connection with the digital signal processing device are equally valid for the computer program stored in the digital signal processing device.

Also, all features, benefits and effects described in connection with the configurator and its interaction with the digital signal processing device and with the digital signal processing system are equally valid for the computer program stored in the configurator; and vice versa.

### Brief description of the drawings

In the following various embodiments of the digital signal processing device and of a respective configurator are described by making reference to the drawings, in which:
- Fig. 1: shows a schematic illustration of a digital signal processing system comprising a digital signal processing device and comprising a configurator,
- Fig. 2: is indicative of a visual representation of a basic constellation,
- Fig. 3: is indicative of the constellation according to Fig. 2 but with signal processing functions positioned on predefined nodes or notches of signal processing paths of the basic constellation,
- Fig. 4: is illustrative of another constellation,
- Fig. 5: is indicative of a further constellation,
- Fig. 6: shows another embodiment of a constellation,
- Fig. 7: is indicative of the structure of a constellation file stored in the primary or in the secondary constellation storage space,
- Fig. 8: is illustrative of another constellation,
- Fig. 9: is indicative of a bitfile group of signal processing functions and of a bitfile representing the constellation according to Fig. 8,
- Fig. 10: is indicative of two bitfiles and a delta bitfile and
- Fig. 11: shows a digital signal processing system comprising one configurator and at least two digital signal processing devices.

### Detailed description

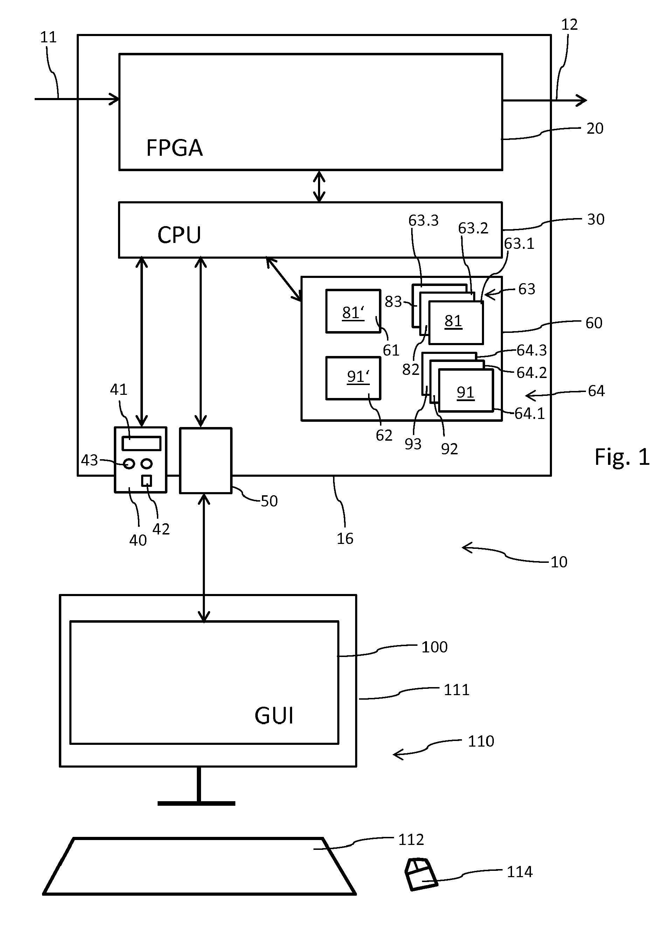

In Fig. 1, a digital signal processing device 16 according to the present invention is schematically shown. The device 16 is configured for processing of digital audio signals, for processing of digital image signals and/or for processing of digital video signals. The digital signal processing device 16 comprises a FPGA 20 configurable in accordance to various user-definable constellations 81, 82, 83. The FPGA comprises a signal input 11 and a signal output 12. Depending on the specific constellation the FPGA 20 may comprise only one of a signal input 11 and a signal output 12. When for instance implemented as a signal analyzer the FPGA 20 may comprise only a signal input 11. When the digital signal processing device 16 is for instance configured as a test generator the FPGA may comprise only a signal output 12.

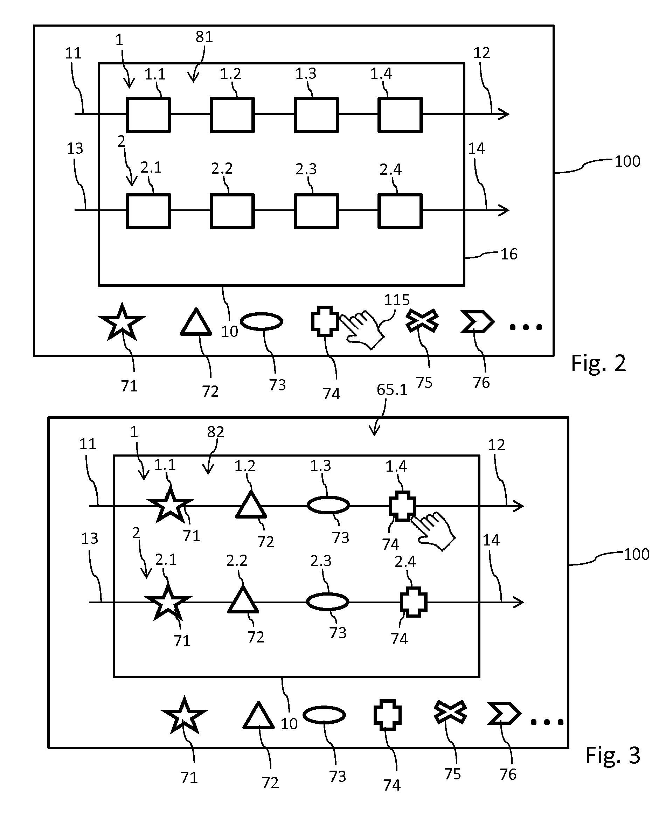

Typically, and from a hardware point of view the FPGA comprises at least one signal input 11 and at least one signal output 12. It may comprise two or even more signal inputs 11, 13 as well as two or even more signal outputs 12, 14 as indicated for instance in Figs. 2-6. The digital signal processing device 16 further comprises a CPU 30, a storage 60 and at least one interface 40, 50. The interface 40 is configured as a front panel user interface. It may comprise a display 41 as well as a selector 42 and at least one button 43 or some other kind of an actuation or selection means.

By means of the front panel user interface 40 the digital signal processing device 16 is reconfigurable during runtime and without any data connection to an external electronic device, such as to a configurator 110. In the present embodiment the digital signal processing device 16 also comprises a data transmission interface 50 which is configured to provide data transmission between the CPU 30 and an external configurator 110. Via the data transmission interface 50 various constellations 81, 82, 83 can be transferred to and from the digital signal processing device 16. Various constellations 81, 82, 83 may be generated, created or modified from default constellations or from base constellations by means of the configurator 110.

For this the configurator 110 typically comprises a housing 111 with a graphical user interface (GUI) 100. Further or optionally the configurator 110 comprises a keyboard 112 and a computer mouse 114 or some other input devices, such as a track pad or track ball. Alternatively, the GUI 100 may comprise a touchscreen or a touch-sensitive display by means of which user input can be processed.

The storage 60 of the digital signal processing device 16 comprises various storage spaces, namely a primary constellation storage space 61 and a primary bitfile storage space 62. There is further provided a secondary constellation storage space 63 and a secondary bitfile storage space 64. The primary constellation storage space 61 is configured to store a single constellation of the FPGA 20. In the primary constellation storage space 61 there is always provided and stored a so-called active constellation 81'. Concurrently and corresponding to the active constellation 81' there is provided and stored an active bitfile 91' in the primary bitfile storage space 62.

The CPU 30 constantly monitors the active constellation 81' and hence the content of the primary constellation storage space 61. If the active constellation 81' should be replaced by another constellation, e.g. by an inactive constellation 82 stored in the secondary constellation storage space 63 said constellation 82 will become the new active constellation 82'. Such a change of the active constellation in the primary constellation storage space 61 will be automatically detected by the CPU 30. A modification to the constellation 81' in the primary constellation storage space 61 leads to the generation or reconfiguration of an active bitfile 91'. Corresponding to the new active constellation 82' the CPU 30 will provide, e.g. load and/or select a new active bitfile 92'. The active bitfile 92' will be loaded into or deployed on the FPGA 20, thereby configuring or reconfiguring the FPGA 20.

The secondary constellation storage space 63 and the secondary bitfile storage space 64 provide storage for numerous inactive constellations 81, 82, 83 and for various inactive bitfiles 91, 92, 93, respectively. For this, the secondary constellation storage space 63 comprises numerous secondary constellation storage blocks 63.1, 63.2, 63.3 and so on. Accordingly, also the secondary bitfile storage space 64 comprises numerous secondary bitfile storage blocks 64.1, 64.2, 64.3 to provide storage space for the various inactive bitfiles 91, 92, 93, respectively. The digital signal processing device 16 and the configurator 110 constitute a digital signal processing system 10. The configurator 110 is configured and capable to reconfigure the FPGA 20 of the digital signal processing device 16.

In Fig. 2, a visual representation of the GUI 100 of the configurator 110 is provided. On the GUI 100 a schematic representation of data processing functions of the digital signal processing device 16 is provided. In the embodiment as illustrated the digital signal processing device 16 comprises a first signal path 1 and a second signal path 2. The first signal path 1 extends from a first signal input 11 to a first signal output 12. The second signal path 2 extends from a second signal input 13 to a second signal output 14. Along the first signal path 1 there are provided various nodes 1.1, 1.2, 1.3, 1.4. Each one of these nodes 1.1, 1.2, 1.3, 1.4 represents a placeholder or a position for a processing function 71, 72, 73, 74, 75, 76, just to mention a few. In the illustrated embodiment the processing function 71 may represents a frame synchronizer, the processing function 72 may a scaler, the processing function 73 may provide video adjustment, the processing function 74 may provide a timer, the processing function 75 may provide a mixer and the processing function 76 may provides a converter.

Also the second signal path 2 comprises various nodes 2.1, 2.2, 2.3, 2.4 serving as placeholders for at least one or several of the processing functions 71, 72, 73, 74, 75, 76. The configuration 81 as illustrated in Fig. 2 is a base configuration that consists only of at least one or several signal paths 1, 2. A base configuration 81 as illustrated in Fig. 2 is void of signal processing functions 71, 72, 73, 74, 75 or 76. A user may now select one or several of the available processing functions 71, 72, 73, 74, 75, 76 and position one or several of the processing functions to one or to several of the nodes 1.1, 1.2, 1.3, 1.4, 2.1, 2.2, 2.3 or 2.4. A correspondingly configured constellation 82 is shown in Fig. 3.

Positioning and/or assigning at least one of the processing functions 71, 72, 73, 74, 75, 76 to one or several of the above mentioned nodes 1.1, ..., 2.4 may be conducted with the aid of a mouse pointer 115, e.g. via a drag and drop scheme and with the aid of a computer program executed by the configurator 110.

Once the constellation 82 has been created it may be stored either in the configurator 110 or it may be stored in the storage 60 of the digital signal processing device 16. For storage of a created or modified constellation 82 the digital signal processing device 16 has to be connected in a data transmitting way with the configurator 110, typically via the data transmission interface 50. It is even conceivable to buffer or to store various constellations 81, 82, 83 in the configurator 110 and to synchronize the configurator 110 with the digital signal processing device 16 and hence with the storage 60 thereof at any later time. The constellation according to Fig. 3 may provide a frame synchronizer with conversion.

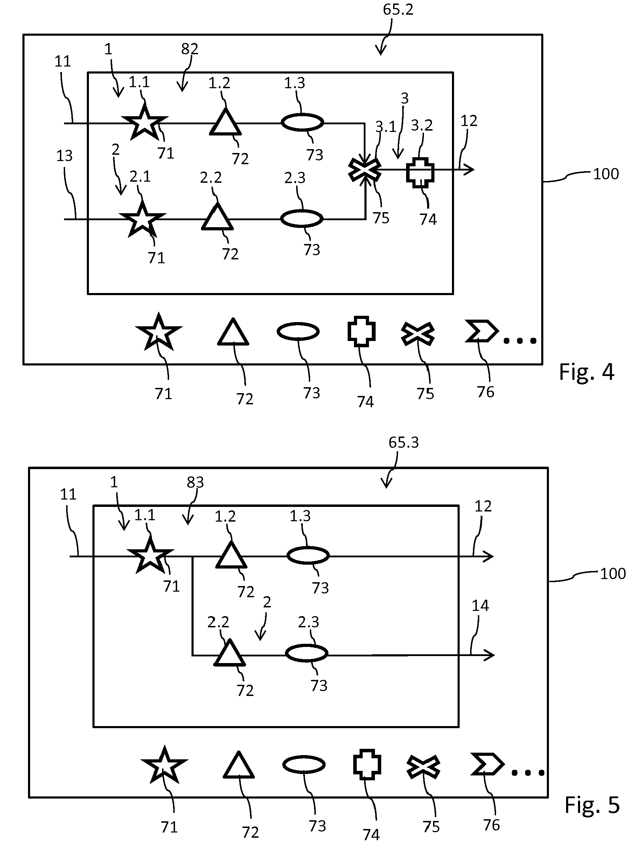

In the embodiment according to Fig. 4, a different constellation 82 to be stored in another secondary constellation storage block 65.2 is shown. There, a first signal path 1 and a second signal path 2 each comprise a sequence of processing functions 71, 72, 73. Contrary to the embodiment as shown in Figs. 2 and 3 the signal paths 1, 2 merge in a node 3.1 from which a third signal path 3 extends to the single signal output 12 of the FPGA 20. On the node 3.1 there is provided a processing function 75 that may be configured as a mixer, i.e. processing two different input signals and generating only one output signal. The constellation as shown in Fig. 4 may provide a mixing stage.

In the constellation according to Fig. 5 there is provided only one signal input 11 but two signal outputs 12, 14. Here, the signal input 11 extends through a first processing function 71. Thereafter and between the nodes 1.1 and 1.2 there branches off a second signal path 2. Downstream of the branch both signal paths 1 and 2 each comprise nodes 1.2, 1.3 and nodes 2.2 and 2.3. Downstream of the node 1.3 there is provided the signal output 12 and downstream of the node 2.3 there is provided the signal output 14. The constellation as shown in Fig. 5 may provide a region of interest unit.

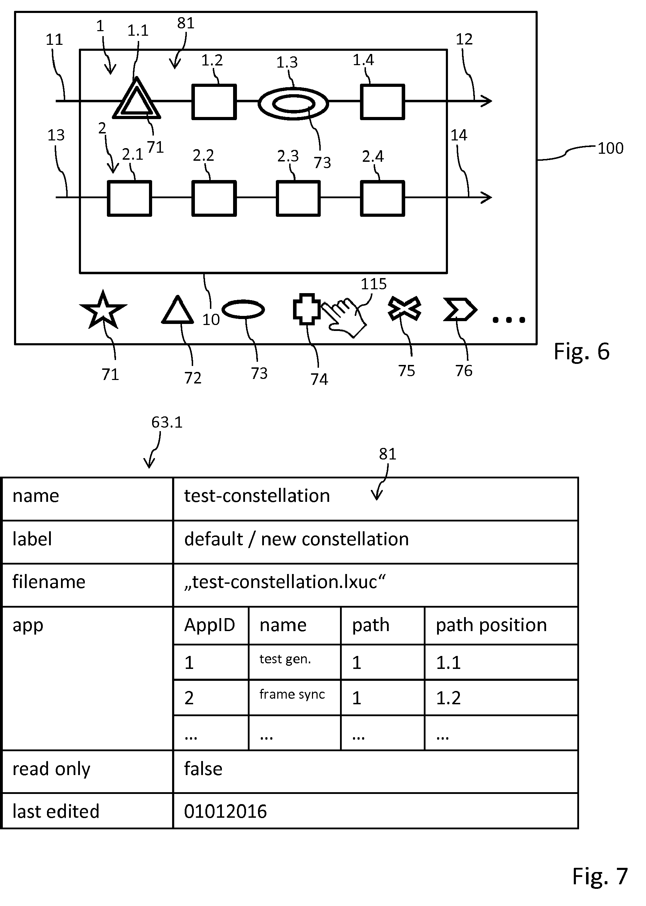

In Fig. 6 another constellation 81 resembling the constellation of Figs. 2 and 3 is shown. There and contrary to the constellation according to Fig. 2 the nodes 1.1 and 1.3 on the first signal path 1 are no longer represented as rectangles. Rather, the node 1.1. is represented as a triangle and the node 1.3 is represented on the GUI 100 as an oval. In this way, the constellation 81 as shown in Fig. 6 comes along with predefined processing functions on nodes 1.1 and 1.3 whereas all other nodes 1.2 and 1.4 of signal path 1 can be arbitrarily provided and assigned with processing functions 71, 72, 73, 74, 75 or 76. It is even conceivable, that a node 1.1 comprises a graphical representation that matches with one, two or even more selected processing functions. Hence, a limited number of generally available processing functions 71, 72 or 74 may be positioned at the node 1.1 whereas other processing functions, such as processing functions 73 or 76 may be positioned at the node 1.3. Hence, there may be different classes of processing functions and there may be classes of nodes that exclusively match with a particular class of processing functions.

In this way even a basic constellation 81 being void of any processing functions may come along with restrictions as to which type of processing functions may be positioned at certain nodes.

In Fig. 7 a schematic or textual representation of a constellation, e.g. in form of a constellation file to be stored in a secondary constellation storage block 63.1 is illustrated. The constellation 81 may comprise a table with at least two columns in order to specify a name, a label, a file name, various apps or processing functions as well as various properties of the constellation, such as a read only or write attribute as well as date information about editing of the constellation. In the presently illustrated embodiment the name of the constellation 81 is 'test-constellation'. It is provided with a default label and the constellation file is denoted as 'test-constellation.lxuc'. In the field 'app' there is provided a sequence of processing functions, abbreviated as 'app id'. Each one of the above mentioned processing functions 71, 72, 73, 74, 75, 76 may be provided with a unique name and with a unique identifier, denoted as 'app id'. For each processing function there is provided information on which path and on which path position the processing function is placed in the respective constellation. The generic path architecture of the base constellation then defines the data flow between the various processing functions of the respective constellation.

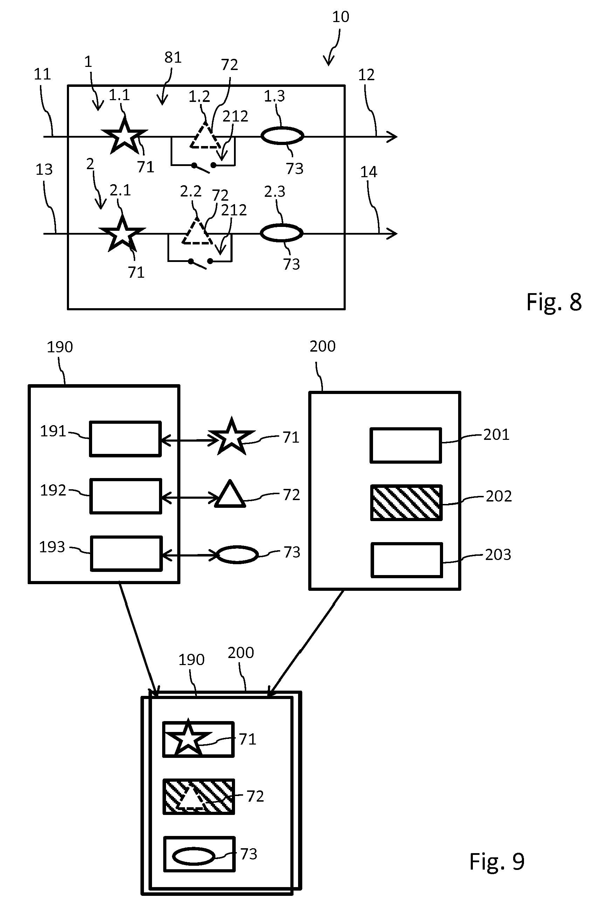

In Fig. 8 another example of a visual representation of a constellation 81 is given. Here, the constellation comprises a first processing path 1 and a second processing path 2. On the processing path 1 there is provided a processing function 71 and a processing function 73. The processing function 71 corresponds to a default bitfile 191. The processing function 72 corresponds to a default bitfile 192 and the processing function 73 matches or corresponds to a third default bitfile 193. The default bitfiles 191, 192, 193 may be stored as separate bitfiles in the secondary bitfile storage space 64. In the present embodiment the default bitfiles 191, 192 and 193 are grouped together in a bitfile group 190. Instead of storing each default bitfile 191, 192, 193 separately the bitfile group 190 may be stored together with an application mask 200. The application mask 200 is indicative of active and inactive signal processing functions 71. 72. 73 of the bitfile group 190.

As indicated in Fig. 9, the illustrated application mask 200 comprises three separate mask sections 201, 202 and 203. Among the mask sections 201, 202 and 203 only the mask section 202 is configured to deactivate a corresponding processing function 72. So when combining the application mask 200 with the bitfile group 190 the corresponding processing function 72 will be deactivated in the bitfile group 190 per default. The application mask 200, in particular the mask sections 201, 202, 203 are reconfigurable by software commands during runtime of the FPGA 20. In this way, the bitfile group 190 stored and deployed in the FPGA 20 may be reconfigured during runtime, simply by modifying the mask sections 201, 202, 203. In other words, the mask sections 201, 202 and 203 behave and act as virtual switches that enable configuration and reconfiguration of a deployed bitfile during runtime of the FPGA and during runtime of the digital signal processing device 16. By modifying the mask section 202 the signal processing function 72 may be switched on or off during runtime of the FPGA.

A reboot or partial reboot of the FPGA is then not necessary for modifying or reconfiguring of the signal processing provided by the FPGA. In particular any one of the mask sections 201, 202, 203 may be assigned to a signal processing function 71, 72, 73. By means of a software implemented modification of the mask sections 201, 202, 203 respective default bitfiles may be switched off or may be switched on during runtime of the FPGA 20.

The application mask may be equally applied or combined with any other arbitrary bitfile. In this way any signal processing function provided by a bitfile and/or deployed in the FPGA can be activated or deactivated by means of the application mask during runtime of the FPGA 20.

The mask section 202 according to Fig. 9 may represent a configurable switch 212 in the representation of Fig. 8. The mask section 202 and the corresponding virtual and software activatable switch 212 bypasses the processing function 72. By means of a respective software command during runtime, this bypass can be set aside, e.g. by closing the switch 212. In addition to this storage and grouping of various default bitfiles 191, 192, 193 in a bitfile group 190 is beneficial in terms of saving storage capacity and for reducing computational efforts to provide a bitfile on the basis of a given user-defined constellation 81, 82 or 83.

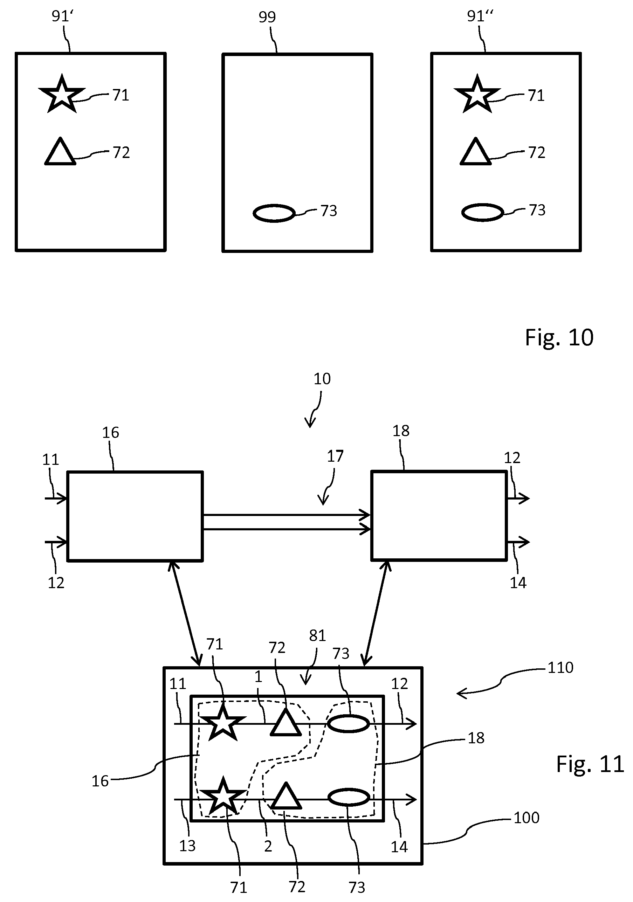

In Fig. 10 there is further illustrated the capability of the CPU 30 to analyze an existing or an active bitfile 91' with a new bitfile 91". As shown in Fig. 10 and as it is apparent from a comparison of the active bitfile 91' and the new bitfile 91" being intended to replace the active bitfile 91', the new bitfile 91" comprises an additional processing function 73. Hence, the CPU 30 is configured to generate or to provide a delta bitfile 99 representing the difference between the active bitfile 91' and the new bitfile 91". Instead of deploying and loading a complete new bitfile 91" into the FPGA 20 upon reconfiguration of the FPGA 20 it is intended that only the delta bitfile 99 is loaded into the FPGA 20. The time for reconfiguring of the FPGA 20 as well as computational efforts to deploy the new bitfile 91" in the FPGA 20 can therefore be kept at a minimum. Loading of only one or several delta bitfiles 99 into the FPGA comes along with a partial reboot of the FPGA. Loading of one or several delta bitfiles at a time into the primary bitfile storage space 62 may trigger a partial reboot of the FPGA. Hence, only a portion of the FPGA will then be subject to a reboot or to a reconfiguration while other and/or the residual portions of the FPGA remain unaffected. A procedure for rebooting can be accelerated, an eventual downtime of the FPGA can be reduced and computational effort required for a reconfiguration can be kept on a rather low or moderate level.

In Fig. 11 there is further shown a digital signal processing system 10 comprising a first digital signal processing device 16 and a second digital signal processing device 18 both connected to a common configurator 110. In Fig. 11 there is further shown a representation of the GUI 100 of the configurator 110. Comparable to the embodiment as shown in Figs. 2 or 3 the constellation 81 to be deployed on the combination of digital signal processing devices 16 and 18 comprises a first signal path 1 and a second signal path 2. The first signal path 1 comprises a first signal input 11 and a first signal output 12. The second signal path 2 comprises a second signal input 13 and a second signal output 14

On the first signal path 1 there are provided three processing functions 71, 72, 73. On the second signal path there are provided similar processing functions 71, 72, 73. But here, a twofold implementation of the three processing functions 71, 72 and 73 on both signal paths 1, 2 would exceed the computational capabilities and the hardware specifications of one digital signal processing device 16. For this purpose and for realizing the constellation 81 the first digital signal processing device 16 is coupled to the second digital signal processing device 18 via a connection 17, that may be implemented or provided by a network connection.

As indicated in Fig. 11 on the GUI 100 the first digital signal processing device 16 is configured to provide the functionality of the first two signal processing functions 71, 72 of the first signal path and to provide a first processing function 71 of the second signal path 2. Complementary to this, the second digital signal processing device 18 is configured to provide the third signal processing function 73 of the first signal path 1 and to provide the second and the third processing functions 72, 73 of the second signal path 2. Here, the signal paths 1 and 2 extend across the first and the second digital signal processing devices 16, 18. A data transmission between the signal processing functions 72 and 73 of the first signal path 1 and a signal transmission between the processing functions 71 and 72 of the second signal path 2 is provided by the connection 17.

In principle, the configurator 110 can be connected to numerous digital signal processing devices and may provide a combined configuration of these. Whole clusters of digital signal processing devices 16, 18 and arbitrary constellations of digital signal processing devices 16, 18 can be configured or reconfigured with a single configurator 110. Almost any arbitrary hardware component of different size and different computational capabilities can be grouped together to provide almost any kind of digital signal processing.

### Reference Numerals

- 1: signal path
- 2: signal path
- 3: signal path
- 1.1-1.4: node
- 2.1-2.4: node
- 3.1-3.2: node
- 10: digital signal processing system
- 11: signal input
- 12: signal output
- 13: signal input
- 14: signal output
- 16: digital signal processing device
- 17: connection
- 18: digital signal processing device
- 20: FPGA
- 30: CPU
- 40: interface
- 41: display
- 42: selector
- 43: button
- 50: interface
- 60: storage
- 61: primary constellation storage space
- 62: primary bitfile storage space
- 63: secondary constellation storage space
- 63.1-63.3: storage block
- 64: secondary bitfile storage space
- 64.1-64.3: storage block
- 71: processing function
- 72: processing function
- 73: processing function
- 74: processing function
- 75: processing function
- 76: processing function
- 81: constellation
- 82: constellation
- 83: constellation
- 91: bitfile
- 92: bitfile
- 93: bitfile
- 100: GUI
- 110: configurator
- 111: housing
- 112: keyboard
- 114: computer mouse
- 115: mouse pointer
- 190: bitfile group
- 191: default bitfile
- 192: default bitfile
- 193: default bitfile
- 200: application mask
- 201: mask section
- 202: mask section
- 203: mask section
- 212: switch

## Claims

1. A digital signal processing device (16) for processing of digital audio signals, image signals or video signals, the processing device comprising:
- a field programmable gate array FPGA (20) configurable in accordance to various user-definable constellations (81, 82, 83),
- at least one of a signal input (11, 13) and a signal output (12, 14) connected to the FPGA (20),
- a storage (60),
- at least one interface (40, 50), and
- a central processing unit CPU (30) connected to the FPGA (20), connected to the storage (60) and connected to the at least one interface (40, 50),
- wherein the storage (60) comprises a primary constellation storage space (61) configured to store an active constellation (81') of the FPGA (20) and wherein the storage (60) comprises at least one secondary constellation storage space (63) configured to store at least one or several inactive constellations (82, 83) of the FPGA (20).

2. The device according to claim 1, wherein the storage (60) comprises a primary bitfile storage space (62) configured to store an active bitfile (91') of the FPGA (20) currently deployed on the FPGA (20), wherein the active bitfile (91') corresponds to the active constellation (81').

3. The device according to claim 2, wherein the storage (60) comprises a secondary bitfile storage space (64) configured to store at least one or several inactive bitfiles (92, 93) deployable on the FPGA (20).

4. The device according to any one of the preceding claims, wherein the constellations (81, 82, 82) are each descriptive of:
- a signal path (1, 2, 3) inside the FPGA (20), and optionally of
- at least one signal processing function (71, 72, 73, 74, 75, 76) on the signal path (1, 2, 3).

5. The device according to any one of the preceding claims 3 or 4, wherein the CPU (30) is configured to provide a bitfile (91, 92, 93) on the basis of a constellation (81, 82, 83) and to store the provided bitfile (91) as an active bitfile (91') in the primary bitfile storage space (62) or to store the generated bitfile (92, 93) as a passive bitfile (92, 93) in the secondary bitfile storage space (64).

6. The device according to claim 4 or 5, wherein for providing a bitfile (91, 92, 93) on the basis of a constellation (81, 82, 83), the CPU (30) is configured to load at least one or several default bitfiles (191, 192, 193) from the secondary bitfile storage space (64), wherein each one of the default bitfiles (191, 192, 193) is configured to deploy a signal processing function (71, 72, 73, 74, 75, 76) of the constellation (81, 82, 83) on the FPGA (20).

7. The device according to any one of the preceding claims 4 to 6, wherein for providing of a bitfile (91, 92, 93) on the basis of a constellation (81, 82, 83), the CPU (30) is configured:
- to select at least two default bitfiles (191, 192, 193), to group together the at least two default bitfiles (191, 192, 193) and to form a bitfile group (190), wherein each one of the default bitfiles (191, 192, 193) is configured to deploy a signal processing function (71, 72, 73, 74, 75, 76) of the constellation (81, 82, 83) on the FPGA (20), and
- to set up and to apply an application mask (200) to the bitfile group (190), wherein the application mask (200) is indicative of active and inactive signal processing functions (71, 72, 73), and
- to store the bitfile group (190) together with the application mask (200).

8. The device according to claim 7, wherein when deployed in the FPGA (20), the application mask (200) is controllable via a software command for selective activation or deactivation of processing functions (71, 72, 73, 74, 75. 76) during runtime of the FPGA (20).

9. The device according to any one of the preceding claims 2 to 8, wherein the CPU (30):
- is configured to monitor the primary constellation storage space (61),
- wherein the CPU (30) is configured to provide an active bitfile (91') on the basis of an active constellation (81') and to store the active bitfile (91') in the primary bitfile storage space (62) when a new constellation (81) is stored as an active constellation (81') in the primary constellation storage space (61),
- and wherein the CPU (30) is configured to deploy the active bitfile (91') on the FPGA (20) when the active bitfile (91') is stored in the primary bitfile storage space (62).

10. The device according to any one of the preceding claims, wherein the CPU (30) is configured to load an inactive constellation (82, 83) from the secondary constellation storage space (63) and to store the loaded inactive constellation (82, 83) as an active constellation (82', 83') in the primary constellation storage space (61).

11. The device according to any one of the preceding claims 3 to 10, wherein the CPU (30) is configured to load an inactive bitfile (92, 93) from the secondary bitfile storage space (64) and to store the loaded inactive bitfile (92, 93) as an active bitfile (92', 93') in the primary bitfile storage space (62).

12. The device according to any one of the preceding claims 7 to 9, wherein for replacement of an active bitfile (91') currently deployed on the FPGA (20) by a new bitfile (91 ") the CPU (30) is configured to determine a delta bitfile (99) representing a difference between the active bitfile (91') and the new bitfile (91 ") and wherein the CPU (30) is configured to modify and/or to reconfigure the currently deployed active bitfile (91') by the delta bitfile (99).

13. The device according to any one of the preceding claims, wherein the at least one interface (40, 50) is one a front panel user interface (40) and a data transmission interface (50), wherein the front panel user interface (40) enables selection of one of the constellations (81, 82, 83) stored in the secondary constellation storage space (63) and enables reconfiguration of the FPGA (30) on the basis of the selected constellation (81, 82, 83) and wherein the data transmission interface (50) is configured to provide data transmission between the CPU (30) and an external configurator (110) to enable configuration and/or re-configuration of constellations (81, 82, 83).

14. A configurator (110) connectable to at least one digital signal processing device (16) according to any one of the preceding claims, the configurator (110) comprising:
- a graphical user interface GUI (100),
- wherein the configurator (110) is configured to visualize, to define and to modify user-definable constellations (81, 82, 83) of the digital signal processing device (16) and
- wherein the configurator (110) is configured to transfer constellations (81, 82, 83) to the digital signal processing device (16) and to store the constellations in the storage (60) of the digital signal processing device (16).

15. A computer program stored in a configurator (110) according to claim 14, the computer program comprising executable instructions:
- to visualize a signal path (1, 2) inside an FPGA (20) of a digital signal processing device (16) according to any one of the preceding claims 1 to 13 on a graphical user interface GUI (100) of the configurator (110),
- to select at least one constellation (81) of several constellations (81, 82, 83),
- to transmit the selected constellation (81) as an active constellation (81') or as an inactive constellation (81) to the digital signal processing device (16).
